# EUROPÄISCHE PATENTANMELDUNG

(11) **EP 4 633 300 A1**
(43) Veröffentlichungstag der Anmeldung: **15.10.2025**
(21) Anmeldenummer: 25168091.4
(22) Anmeldetag: 02.04.2025
(51) Int. Cl.: H05K 7/14

(54) **VERBINDUNGSVORRICHTUNG FÜR EINE AUTOMATISIERUNGSPLATTFORM SOWIE AUTOMATISIERUNGSPLATTFORM**

(30) Priorität: 12.04.2024 DE 102024110294
(71) Anmelder: Murrelektronik GmbH, 71570 Oppenweiler (DE)
(72) Erfinder: Prein, Olaf, 32676 Lügde-Rischenau (DE); Feisst, Heiko, 73278 Schlierbach (DE); Roolf, Tim, 71522 Backnang (DE)
(74) Vertreter: Bösherz Goebel Patentanwälte

(57) **Zusammenfassung**

Die Erfindung betrifft eine Verbindungsvorrichtung (10) für eine Automatisierungsplattform, umfassend ein Kontaktierungsaufnahmeelement (12), das ausgebildet ist, eine Kontaktierung mit einem zu dem Kontaktierungsaufnahmeelement (12) korrespondierenden Kontaktierungselement (22) eines Funktionsmoduls (20) bereitzustellen und darüber zumindest einen von einem Hauptenergiefluss, einem Hilfsenergiefluss und einem Datenfluss an das Funktionsmodul (20) bereitzustellen und ein Erdungsaufnahmeelement (15), das ausgebildet ist, eine Erdung für das Funktionsmodul bereitzustellen.

## Beschreibung

Die vorliegende Erfindung betrifft eine Verbindungsvorrichtung für eine Automatisierungsplattform sowie eine Automatisierungsplattform mit einer solchen Verbindungsvorrichtung und eine Anlage.

Aus dem Stand der Technik ist es bekannt, dass modulare Automatisierungslösungen dafür genutzt werden, um in einer industriellen Anlage elektrische Geräte über Energieleitungen mit Energie zu versorgen und über Steuerungsleitungen, wie z. B. Feldbusleitungen, anzusteuern. Die Modularität wird dabei oft dadurch erreicht, dass einzelne, voneinander unabhängige Funktionsmodule verwendet werden, die individuell konfiguriert und kombiniert werden können. Dies hat den Vorteil, dass die Automatisierungslösungen flexibel an die jeweiligen Anforderungen der industriellen Anlage angepasst werden können und somit eine hohe Effizienz und Wirtschaftlichkeit gewährleisten.

Die Druckschrift US 2013/0342152 A1 offenbart eine Mehrwellenmotorantriebsvorrichtung, bei welcher mindestens ein Verstärkermodul, ein Steuersubstrat und ein Leistungssubstrat vorgesehen sind.

Die Druckschriften WO 2012/000808 A1, WO 2023/088883 A1 und EP 2 728 673 B1 offenbaren weitere gattungsgemäße Lösungen.

Es ist bei herkömmlichen Lösungen häufig ein Problem, dass eine Montage von Funktionsmodulen einer Automatisierungsplattform aufwändig und fehleranfällig sein kann. Es ist daher eine Aufgabe der vorliegenden Erfindung, die voranstehend beschriebenen Nachteile zumindest teilweise zu beheben. Es ist insbesondere eine Aufgabe der vorliegenden Erfindung, die Verbindung von Funktionsmodulen mit einer gemeinsamen Verbindungsvorrichtung zu verbessern.

### Offenbarung der Erfindung

Gegenstand der Erfindung ist eine Verbindungsvorrichtung mit den Merkmalen des Anspruchs 1 sowie eine Automatisierungsplattform mit den Merkmalen des Anspruchs 11 und eine Anlage mit den Merkmalen des Anspruchs 15. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Verbindungsvorrichtung beschrieben sind, selbstverständlich auch im Zusammenhang mit der erfindungsgemäßen Automatisierungsplattform sowie der Anlage und jeweils umgekehrt, so dass bezüglich der Offenbarung zu den einzelnen Erfindungsaspekten stets wechselseitig Bezug genommen wird bzw. werden kann.

Gegenstand der Erfindung ist insbesondere eine Verbindungsvorrichtung für eine Automatisierungsplattform.

Die erfindungsgemäße Verbindungsvorrichtung kann umfassen:
- ein Kontaktierungsaufnahmeelement, das ausgebildet ist, eine Kontaktierung mit einem zu dem Kontaktierungsaufnahmeelement korrespondierenden Kontaktierungselement eines Funktionsmoduls bereitzustellen und darüber zumindest einen von einem Hauptenergiefluss, einem Hilfsenergiefluss und einem Datenfluss an das Funktionsmodul bereitzustellen und/oder
- ein Erdungsaufnahmeelement, das ausgebildet ist, eine Erdung für das Funktionsmodul bereitzustellen.

Optional ist es daher möglich, dass das Kontaktierungsaufnahmeelement ausgebildet ist, die Kontaktierung mit dem Kontaktierungselement bereitzustellen. Das Kontaktierungselement kann Teil des Funktionsmoduls sein. Ferner kann das Kontaktierungselement zum Kontaktierungsaufnahmeelement korrespondierend ausgebildet sein. Korrespondierend meint vorliegend insbesondere, dass die beiden Elemente zueinander passen, insbesondere funktional und/oder räumlich-körperlich, kompatibel miteinander sind, gleich oder komplementär zueinander geformt sind und/oder ausgebildet sind, einander zu ergänzen.

Darüber hinaus kann das Kontaktierungsaufnahmeelement optional ausgebildet sein, über diese Kontaktierung zumindest einen von einem Hauptenergiefluss, einem Hilfsenergiefluss und einem Datenfluss, d. h. einen Hauptenergiefluss und/oder einen Hilfsenergiefluss und/oder einen Datenfluss, an das Funktionsmodul bereitzustellen. Dies bedeutet vorzugsweise, dass die Kontaktierung als eine elektrische Kontaktierung ausgeführt sein kann, welche den Hauptenergiefluss und/oder den Hilfsenergiefluss und/oder den Datenfluss elektrisch leitet und somit das Kontaktierungsaufnahmeelement elektrisch mit dem Kontaktierungselement für die Übertragung des Hauptenergieflusses und/oder des Hilfsenergieflusses und/oder des Datenflusses verbindet.

Optional kann das Kontaktierungsaufnahmeelement entsprechend zur Bereitstellung des Hauptenergieflusses an das Funktionsmodul und/oder über die Kontaktierung ausgebildet sein. Alternativ oder zusätzlich kann das Kontaktierungsaufnahmeelement zur Bereitstellung des Hilfsenergieflusses an das Funktionsmodul und/oder über die Kontaktierung ausgebildet sein. Der Haupt- und/oder Hilfsenergiefluss kann primär zur Energieversorgung des Funktionsmoduls und/oder zumindest einer weiteren Komponente z. B. in einer industriellen Anlage vorgesehen sein. Der Hauptenergiefluss kann dabei hinsichtlich seiner Spannungshöhe größer, vorzugsweise mindestens zwei- oder vier- oder zehnmal so groß, sein wie der Hilfsenergiefluss. Alternativ oder zusätzlich kann das Kontaktierungsaufnahmeelement zur Bereitstellung des Datenflusses an das Funktionsmodul und/oder über die Kontaktierung ausgebildet sein. Der Datenfluss kann im Gegensatz zum Haupt- und/oder Hilfsenergiefluss nicht primär zur Energieversorgung, sondern zum Datenaustausch vorgesehen sein. Zur Kontaktierung können, falls mehrere von dem Hauptenergie- und dem Hilfsenergie- und dem Datenfluss bereitgestellt werden, auch unterschiedliche Kontaktstellen für diese vorgesehen sein.

Vorteilhafterweise kann die Verbindungsvorrichtung und/oder die Automatisierungsplattform und/oder eine jeweilige erfindungsgemäße Automatisierungsplattform zur Automatisierung bei einer industriellen Anlage wie einer Automatisierungsanlage und/oder der erfindungsgemäßen industriellen Anlage dienen. Entsprechend kann die Energieversorgung über den Haupt- und/oder Hilfsenergiefluss zur Energieversorgung wenigstens einer Komponente bei dieser Anlage dienen und/oder zur Bereitstellung von zumindest einem Prozess und vorzugsweise Automatisierungsprozess vorgesehen sein.

Eine Automatisierungsplattform, für die die erfindungsgemäße Verbindungsvorrichtung eingerichtet und ausgebildet ist, kann eine Hardware, ggf. mit einer zugehörigen Software, verstanden werden, um in einer elektrischen Anlage bestimmte Prozesse zu automatisieren. Bspw. werden hierbei Motoren, vorzugsweise Servomotoren, angesteuert, und mit diesen ein Roboterarm bewegt oder ein Förderband gesteuert. Die Verbindungsvorrichtung kann dabei zumindest Teil der Automatisierungsplattform sein, um eines oder mehrere Funktionsmodule daran anzuschließen und/oder miteinander zu verbinden, und auf diese Weise modular verschiedene Funktionen für die Automatisierung, wie die Ansteuerung der Motoren, bereitzustellen. Dies kann den Vorteil haben, dass die Verbindungsvorrichtung mit den Funktionsmodulen in der Lage versetzt wird, eine Vielzahl von Geräten und Komponenten in einer elektrischen Anlage zu verbinden und/oder zu steuern und/oder auszuwerten, um eine reibungslose und effiziente Automatisierung zu gewährleisten.

Die Modularität kann dadurch erreicht werden, dass die Funktionsmodule als einzelne, insbesondere voneinander unabhängige Module ausgebildet sind, jeweils mit einem eigenen Modulgehäuse und einer Elektronik, die es erlaubt, die Module individuell zu konfigurieren und mit weiteren Funktionsmodulen funktional zu kombinieren. Auch können die Funktionsmodule Daten- und/oder Energieversorgungs-Schnittstellen zueinander und/oder zu Geräten und/oder Komponenten der elektrischen Anlage aufweisen. Es ist bspw. möglich, dass wenigstens eines der an der Verbindungsvorrichtung angeschlossenen Funktionsmodule in der Lage ist, eine kabelgebundene und/oder drahtlose Verbindung zu einem zu steuernden Gerät und/oder einer Komponente herzustellen. Auch kann wenigstens eines der an der Verbindungsvorrichtung angeschlossenen Funktionsmodule dazu ausgeführt sein, eine Energieversorgung für ein zu steuerndes Gerät und/oder einer Komponente und/oder der weiteren angeschlossenen Funktionsmodule bereitzustellen.

Bei der erfindungsgemäßen Verbindungsvorrichtung kann zunächst zumindest ein Kontaktierungsaufnahmeelement vorgesehen sein, das ausgebildet ist, eine Kontaktierung mit einem (jeweiligen) zu dem Kontaktierungsaufnahmeelement korrespondierenden Kontaktierungselement eines Funktionsmoduls bereitzustellen und darüber zumindest einen von einem Hauptenergiefluss, einem Hilfsenergiefluss und/oder einem Datenfluss an das Funktionsmodul bereitzustellen. Eine Kontaktierung meint vorliegend insbesondere das Bereitstellen und/oder Herstellen einer elektrischen, insbesondere signal- und/oder leistungstechnischen Verbindung. Korrespondierend meint vorliegend insbesondere, dass die beiden Elemente zueinander passen, insbesondere funktional und/oder räumlich-körperlich, kompatibel miteinander sind, gleich oder komplementär zueinander geformt sind und/oder ausgebildet sind, einander zu ergänzen. Das zumindest eine Kontaktierungsaufnahmeelement kann ein erstes und/oder zweites und/oder drittes Kontaktierungsaufnahmeelement umfassen. Das erste Kontaktierungsaufnahmeelement kann entsprechend dazu ausgebildet sein, eine Kontaktierung mit einem zu dem ersten Kontaktierungsaufnahmeelement korrespondierenden ersten Kontaktierungselement des Funktionsmoduls bereitzustellen und darüber einen Hauptenergiefluss an das Funktionsmodul bereitzustellen. Das zweite Kontaktierungsaufnahmeelement kann dazu ausgebildet sein, eine Kontaktierung mit einem zu dem zweiten Kontaktierungsaufnahmeelement korrespondierenden zweiten Kontaktierungselement des Funktionsmoduls bereitzustellen und darüber einen Hilfsenergiefluss an das Funktionsmodul bereitzustellen. Das dritte Kontaktierungsaufnahmeelement kann dazu ausgebildet sein, eine Kontaktierung mit einem zu dem dritten Kontaktierungsaufnahmeelement korrespondierenden dritten Kontaktierungselement des Funktionsmoduls bereitzustellen und darüber einen Datenfluss an das Funktionsmodul bereitzustellen.

Dabei dient der Begriff "Aufnahme" bei dem Kontaktierungsaufnahmeelement insbesondere zunächst dazu, diese Elemente von dem dazu korrespondierenden Kontaktierungselement des Funktionsmoduls begrifflich abzugrenzen und umfasst nicht zwangsläufig eine physikalische Aufnahme des Kontaktierungselements, sondern das Kontaktierungsaufnahmeelement stellt lediglich über Kontaktierung und/oder Berührung eine Kontaktierung mit dem Kontaktierungselement des Funktionsmoduls her.

Es kann jedoch auch vorgesehen sein, dass das Kontaktierungsaufnahmeelement eine oder mehrere Aufnahmeeinrichtungen oder -vorrichtungen umfasst, die ausgebildet sind, das Kontaktierungselement physikalisch aufzunehmen, insbesondere damit einzugreifen, einzurasten und/oder ineinanderzugreifen. Insbesondere kann das Kontaktierungsaufnahmeelement eine Steckeraufnahme aufweisen und das Kontaktierungselement einen dazu korrespondierenden Stecker oder andersherum.

Insbesondere kann vorgesehen sein, dass das Kontaktierungsaufnahmeelement eine Stift-Buchsen-Kontaktierung umfasst. Eine Stift-Buchsen-Kontaktierung ist dabei eine Kontaktierungsart, bei der ein oder mehrere Stifte und/oder Stäbe, die auch als männliche Kontaktierung bezeichnet werden können, in eine oder mehrere dazu korrespondierende Buchsen und/oder Steckeraufnahmen, die auch als weibliche Kontaktierung bezeichnet werden können, eingeführt werden und darin eingreifen, beispielsweise durch Haftreibung. Insbesondere weist das Kontaktierungsaufnahmeelement eine oder mehrere Buchsen und/oder Aufnahmen zur Aufnahme eines oder mehrerer Stifte und/oder Stäbe auf und das Kontaktierungselement einen oder mehrere Stifte und/oder Stäbe, die in der bzw. den Buchsen und/oder Aufnahmen des Kontaktierungsaufnahmeelements aufgenommen werden.

Alternativ oder zusätzlich kann vorgesehen sein, dass das Kontaktierungsaufnahmeelement eine Federkontaktierung umfasst. Eine Federkontaktierung ist dabei eine Kontaktierungsart, bei der zumindest einer von dem Kontaktierungsaufnahmeelement und dem Kontaktierungselement zumindest abschnittsweise als Feder ausgebildet ist. Die Feder kann dabei durch eine Formgebung in eine bestimmte Richtung vorgespannt sein, insbesondere in eine Einführrichtung, wie dies im weiteren Verlauf noch beschrieben werden wird. Zusätzlich oder alternativ kann vorgesehen sein, dass das Kontaktierungselement des Funktionsmoduls eine Federkontaktierung umfasst. In diesem Fall kann das Kontaktierungsaufnahmeelement auch als Flächenkontaktierung ausgebildet sein oder alternativ ebenfalls als Federkontaktierung, die jeweils mit einer Federkontaktierung des Funktionsmoduls zusammenwirkt oder andersherum. Dabei kann die Federkontaktierung insbesondere als Federklammer ausgebildet sein. Eine Federklammer ist dabei beispielsweise eine aus zwei Federelementen zusammengesetzte bzw. gebildete Klammer, bei der die Federelemente entgegengesetzt zueinander angeordnet sind, sodass ein dazwischen bestehender Leerraum durch die Vorspannung der Federelemente nach Innen verjüngt wird und dieser Leerraum durch eine Einführbewegung, beispielsweise in Einführrichtung, aufgeweitet wird, sodass das Kontaktierungselement des Funktionsmoduls darin aufgenommen und sicher gehalten werden kann.

Wieder alternativ oder zusätzlich kann es vorgesehen sein, dass das Kontaktierungsaufnahmeelement eine Flächenkontaktierung umfasst. Eine Flächenkontaktierung kann dabei als flächiges Element ausgebildet sein und beispielsweise mit einer dazu korrespondierenden Fläche bzw. einer Flächenaufnahme zusammenwirken, die zumindest abschnittsweise flächig mit der Flächenkontaktierung überlappt und so eine Kontaktierung herstellt. Alternativ oder zusätzlich kann die Flächenkontaktierung auch mit einer Federkontaktierung zusammenwirken und eines solche aufnehmen bzw. kontaktieren. Insbesondere können sowohl an dem Kontaktierungsaufnahmeelement als auch an dem dazu korrespondierenden Kontaktierungselement Mittel oder Elemente vorgesehen sein, die sowohl eine Stift-Buchsen-Kontaktierung als auch eine Federkontaktierung als auch eine Flächenkontaktierung ermöglichen, unterstützen und/oder bereitstellen.

Es kann dabei ein Erdungsaufnahmeelement vorgesehen sein, das ausgebildet ist, eine Erdung für das Funktionsmodul bereitzustellen. Das Erdungsaufnahmeelement stellt eine Erdungsfunktion für das Funktionsmodul bereit, beispielsweise weil es einen leitenden Kontakt zwischen dem Funktionsmodul und einer Erdung der Verbindungsvorrichtung bzw. der Automatisierungsplattform herstellt bzw. bereitstellt. Insbesondere stellt das Erdungsaufnahmeelement einen Potentialausgleich von dem Funktionsmodul zur Erde hin bereit. Dabei ist auch in Bezug auf das Erdungsaufnahmeelement und insbesondere auch auf die im weiteren Verlauf noch erläuterten Ausgestaltungen des Erdungsaufnahmeelement und ggf. dazu korrespondierende Elemente an dem Funktionsmodul, anzumerken, dass der Begriff "Aufnahme" auch in diesem Zusammenhang dazu verwendet wird, dieses Element von einem dazu korrespondierenden Element des Funktionsmoduls begrifflich abzugrenzen und umfasst nicht zwangsläufig eine physikalische Aufnahme, sondern das Erdungsaufnahmeelement stellt lediglich über Kontaktierung und/oder Berührung eine Erdung für das Funktionsmodul her. Es kann jedoch auch vorgesehen sein, dass das Erdungsaufnahmeelement eine oder mehrere Aufnahmeeinrichtungen oder -vorrichtungen umfasst, die ausgebildet sind, korrespondierende Elemente des Funktionsmoduls physikalisch aufzunehmen, insbesondere damit einzugreifen, einzurasten und/oder ineinanderzugreifen, wie dies im weiteren Verlauf noch beschrieben werden wird. Dabei kann das Erdungsaufnahmeelement räumlich und/oder technologisch von dem Kontaktierungsaufnahmeelement beabstandet bzw. getrennt ausgebildet sein, muss es aber nicht, wie dies ebenfalls noch im weiteren Verlauf erläutert werden wird. Durch die erfindungsgemäße Lösung wird eine besonders zuverlässige Erdungskontaktierung für ein Funktionsmodul einer Automatisierungsplattform bereitgestellt.

Von weiterem Vorteil kann vorgesehen sein, dass das Erdungsaufnahmeelement ein Formschlussaufnahmeelement aufweist, wobei das Formschlussaufnahmeelement ausgebildet ist, formschlüssig mit einem dazu korrespondierenden Formschlusselement des Funktionsmoduls einzugreifen, um dadurch eine Erdung bereitzustellen. Dabei können das Formschlussaufnahmeelement und das Formschlusselement insbesondere derart miteinander interagieren bzw. eingreifen, dass eine Bewegung der beiden Elemente zueinander zumindest in einer Richtung erschwert oder verhindert wird. So wird eine besonders sichere Erdung ermöglicht.

Gemäß einer vorteilhaften Weiterbildung der Erfindung kann vorgesehen sein, dass das Erdungsaufnahmeelement ein Befestigungsaufnahmeelement aufweist, wobei das Befestigungsaufnahmeelement ausgebildet ist, an einem dazu korrespondierenden Befestigungselement des Funktionsmoduls befestigt zu werden, um dadurch eine Erdung bereitzustellen. Dabei können insbesondere das Befestigungsaufnahmeelement und das Befestigungselement derart zusammenwirken bzw. interagieren, sodass eine Bewegung der beiden Elemente zueinander zumindest in einer Richtung, insbesondere in alle Richtungen erschwert oder verhindert wird. Dabei kann das Befestigungsaufnahmeelement bzw. das Befestigungselement beispielsweise als Rastelement ausgebildet sein, sodass die beiden Elemente derart ineinander greifen bzw. rasten, dass eine Lösung ohne ein Werkzeug nicht möglich ist. Insbesondere kann das Befestigungsaufnahmeelement bzw. das Befestigungselement als Loch und Schraube bzw. Niet ausgebildet sein, die zerstörungsfrei oder nicht zerstörungsfrei voneinander gelöst werden können. Beispielsweise können auch sowohl am Befestigungsaufnahmeelement als auch am Befestigungselement ein Loch vorgesehen sein, durch das ein Befestigungsmittel, wie eine Schraube oder ein Niet durchgeführt wird und ggf. mit einem weiteren Befestigungsmittel, wie einer Mutter, oder durch eine Verquetschung das Befestigungsaufnahmeelement und das Befestigungselement aneinander befestigen. So wird eine besonders sichere Erdung ermöglicht.

Vorteilhafterweise kann im Rahmen der Erfindung vorgesehen sein, dass das Erdungsaufnahmeelement ein Erdungsflächenaufnahmeelement aufweist, wobei das Erdungsflächenaufnahmeelement ausgebildet ist, flächig mit einem dazu korrespondierenden Erdungsflächenelement des Funktionsmoduls einzugreifen, um dadurch eine Erdung bereitzustellen. Dabei kann das Erdungsflächenaufnahmeelement als flächiges Element ausgebildet sein und beispielsweise mit der dazu korrespondierenden Fläche bzw. dem Flächenaufnahmeelement zusammenwirken, sodass dieses zumindest abschnittsweise flächig mit der Erdungsflächenaufnahmeelement überlappt und so eine Erdung herstellt. So wird eine besonders einfache Erdung bereitgestellt.

Ferner kann im Rahmen der Erfindung vorgesehen sein, dass das Erdungsaufnahmeelement ein Erdungsbandaufnahmeelement aufweist, wobei das Erdungsbandaufnahmeelement ausgebildet ist, mit einem dazu korrespondierenden Erdungsbandelement des Funktionsmoduls einzugreifen, um dadurch eine Erdung bereitzustellen. Die Erdung wird in diesem Fall durch ein Erdungsband sichergestellt, welches zwischen dem Erdungsbandaufnahmeelement und dem Erdungsbandelement verbunden ist und hierüber einen Potentialausgleich bereitstellt. So wird eine besonders sichere Erdung ermöglicht.

Optional kann es vorgesehen sein, dass das Erdungsaufnahmeelement ein Erdungskabelaufnahmeelement aufweist, wobei das Erdungskabelaufnahmeelement ausgebildet ist, mit einem dazu korrespondierenden Erdungskabelelement des Funktionsmoduls einzugreifen, um dadurch eine Erdung bereitzustellen. Die Erdung wird in diesem Fall durch ein Erdungskabel sichergestellt, welches zwischen dem Erdungsbandaufnahmeelement und dem Erdungsbandelement verbunden ist und hierüber einen Potentialausgleich bereitstellt. So wird eine besonders sichere Erdung ermöglicht.

Optional kann es vorgesehen sein, dass der Hauptenergiefluss eine Wechselspannung von bis zu 1000 Volt und/oder eine Gleichspannung von bis zu 1500 Volt und/oder eine Wechselspannung im Bereich von 70 Volt bis 1000 Volt und/oder eine Gleichspannung im Bereich von 130 Volt bis 1500 Volt, und bevorzugt eine Wechselspannung von im Wesentlichen 400 Volt oder eine Gleichspannung im Bereich von 650 V bis 700 V, umfasst Alternativ oder zusätzlich kann vorgesehen sein, dass der Hilfsenergiefluss eine Wechselspannung von bis zu 50 Volt und/oder eine Gleichspannung bis zu 120 Volt und/oder eine Wechselspannung im Bereich von 0,01 Volt bis 50 Volt und/oder eine Gleichspannung im Bereich von 0,01 Volt bis 120 Volt, und bevorzugt eine Gleichspannung von im Wesentlichen 24 V oder 48 V umfasst.

Insbesondere kann es vorgesehen sein, dass der Datenfluss ausgebildet ist, Daten- und vorzugsweise Feldbussignale zu übertragen, vorzugsweise zur Kommunikation mit wenigstens einem der zu steuernden Geräte.

Gemäß einer vorteilhaften Weiterbildung der Erfindung kann vorgesehen sein, dass die Verbindungsvorrichtung ein weiteres, zumindest zweites Kontaktierungsaufnahmeelement umfasst, das ausgebildet ist, eine Kontaktierung mit einem zu dem weiteren Kontaktierungsaufnahmeelement korrespondierenden weiteren Kontaktierungselement des Funktionsmoduls bereitzustellen und darüber zumindest einen weiteren von einem Hauptenergiefluss, einem Hilfsenergiefluss und/oder einem Datenfluss an das Funktionsmodul bereitzustellen.

Optional kann es vorgesehen sein, dass das erste Kontaktierungsaufnahmeelement in einer ersten Ebene angeordnet ist und das weitere zweite Kontaktierungsaufnahmeelement in einer zweiten Ebene, die zu der ersten Ebene gewinkelt ist, angeordnet ist. Zwischen der ersten Ebene der Verbindungsvorrichtung und der zweiten Ebene der Verbindungsvorrichtung kann somit ein Winkel ausgebildet sein. Der Winkel zwischen den zwei Ebenen kann dabei insbesondere größer 15°, größer 30°, größer 45°, größer 60°, größer 75°, größer 80° oder größer 85° sein. Alternativ oder zusätzlich kann der Winkel zwischen den zwei Ebenen der Verbindungsvorrichtung kleiner als 165°, kleiner 150°, kleiner 135°, kleiner 120°, kleiner 105°, kleiner 100° oder kleiner 95° sein. Insbesondere liegt der Winkel zwischen 85° und 95° und beträgt weiter insbesondere ungefähr, im Wesentlichen oder genau 90°. Insbesondere ist die erste Ebene, in der bzw. entlang der das erste Kontaktierungsaufnahmeelement angeordnet ist, in einer Ebene ungefähr, im Wesentlichen oder genau parallel zu einem Erdboden bzw. Fußboden und die zweite Ebene, in der bzw. entlang der das zweite Kontaktierungsaufnahmeelement angeordnet ist, in einer Ebene ungefähr, im Wesentlichen oder genau senkrecht zu einem Erdboden bzw. Fußboden. Hierdurch wird es ermöglicht, ein Funktionsmodul in zwei voneinander verschiedenen Ebenen anzuschließen bzw. zu kontaktieren und dabei insbesondere auch sicher zu befestigen, um einen oder mehrere von einem Hauptenergiefluss, einem Hilfsenergiefluss und/oder einem Datenfluss in den zwei Ebenen an das Funktionsmodul bereitzustellen.

Von weiterem Vorteil kann vorgesehen sein, dass die erste Ebene und die zweite Ebene der Verbindungsvorrichtung derart zueinander angeordnet sind, dass sie eine Einführung des Funktionsmoduls in einer Einführrichtung ermöglichen, die im Wesentlichen senkrecht zu einer von der ersten Ebene und der zweiten Ebene ist und wobei das Erdungsaufnahmeelement derart angeordnet und ausgebildet ist, dass es in der Einführrichtung eine Erdung bereitstellt. Wie zuvor ausgeführt können die erste und zweite Ebene insbesondere ungefähr, im Wesentlichen oder genau in einem rechten Winkel zueinander angeordnet sein. Dabei kann es vorgesehen sein, dass das Funktionsmodul in einer Einführrichtung an die Verbindungsvorrichtung geführt wird, die ungefähr, im Wesentlichen oder genau senkrecht zur ersten Ebene verläuft und die ungefähr, im Wesentlichen oder genau parallel zur zweiten Ebene verläuft.

Ferner kann im Rahmen der Erfindung vorgesehen sein, dass das Erdungsaufnahmeelement an dem Kontaktierungsaufnahmeelement angeordnet ist und die Verbindungsvorrichtung ein weiteres Erdungsaufnahmeelement umfasst, das an dem weiteren, zweiten Kontaktierungsaufnahmeelement angeordnet ist. Es kann somit insbesondere das erste Kontaktierungsaufnahmeelement das erste Erdungsaufnahmeelement aufweisen und das zweite Kontaktierungsaufnahmeelement ein weiteres, zweites Erdungsaufnahmeelement. Dabei können die beiden Erdungsaufnahmeelemente insbesondere unterschiedlich bzw. verschieden voneinander ausgebildet sein. Insbesondere kann das erste Erdungsaufnahmeelement eines oder mehrere von einem Formschlussaufnahmeelement, einem Befestigungsaufnahmeelement, einem Erdungsflächenaufnahmeelement, einem Erdungsbandaufnahmeelement und einem Erdungskabelaufnahmeelement umfassen und das zweite Erdungsaufnahmeelement eine oder mehrere andere von einem Formschlussaufnahmeelement, einem Befestigungsaufnahmeelement, einem Erdungsflächenaufnahmeelement, einem Erdungsbandaufnahmeelement und einem Erdungskabelaufnahmeelement. Hierdurch können die jeweils positiven Effekte der jeweiligen Erdungsaufnahmearten synergistisch kombiniert werden und so eine besonders sichere Erdung hergestellt werden, die auch redundant bzw. ausfallsicher ist.

Ebenfalls Gegenstand der Erfindung ist eine Automatisierungsplattform, umfassend eine Verbindungsvorrichtung nach einer oder mehrerer der zuvor beschriebenen Ausführungsformen, sowie zumindest ein Funktionsmodul. Insbesondere kann die Automatisierungsplattform mehr als ein Funktionsmodul aufweisen, beispielsweise zwei, drei oder mehr, wovon zumindest ein Funktionsmodul über eine Verbindungsvorrichtung nach einer oder mehrerer der zuvor beschriebenen Ausführungsformen mit der Automatisierungsplattform verbunden und/oder verbindbar ist.

Optional kann es vorgesehen sein, dass die Automatisierungsplattform eine weitere Verbindungsvorrichtung nach einer oder mehrerer der zuvor beschriebenen Ausführungsformen, wobei jede der zumindest zwei Verbindungsvorrichtungen mit zumindest je einem Funktionsmodul verbindbar ist, wobei die Verbindungsvorrichtungen ausgebildet sind, um zumindest einen von dem Hauptenergiefluss, dem Hilfsenergiefluss und/oder dem Datenfluss an die Funktionsmodule bereitzustellen. Dabei kann insbesondere jedes der Funktionsmodule eine unterschiedliche Funktion für die Automatisierungsplattform bereitstellen. Insbesondere kann eine erste Verbindungsvorrichtung nach einer oder mehrerer der zuvor beschriebenen Ausführungsformen vorgesehen sein, die mit einem ersten Funktionsmodul verbindbar und/oder verbunden ist und eine zweite Verbindungsvorrichtung nach einer oder mehrerer der zuvor beschriebenen Ausführungsformen, die mit einem zweiten, insbesondere von dem ersten Funktionsmodul verschiedenen Funktionsmodul verbindbar und/oder verbunden ist. Das erste Funktionsmodul kann dabei eine erste Funktion innerhalb der Automatisierungsplattform bereitstellen und das zweite Funktionsmodul eine zweite, von der ersten Funktion verschiedene Funktion bereitstellen.

Gemäß einem weiteren Vorteil kann vorgesehen sein, dass die Verbindungsvorrichtungen derart zueinander angeordnet und ausgebildet sind, dass sie zumindest einen von dem Hauptenergiefluss, dem Hilfsenergiefluss und/oder dem Datenfluss seriell an die Funktionsmodule bereitstellen. Insbesondere sind auch die Funktionsmodule derart zueinander angeordnet und ausgebildet, dass sie zumindest einen von dem Hauptenergiefluss, dem Hilfsenergiefluss und/oder dem Datenfluss seriell an anderen die Funktionsmodule bereitstellen. Mit anderen Worten sind die ersten Kontaktierungsaufnahmeelemente und/oder die zweiten Kontaktierungsaufnahmeelemente bzw. der daran anliegende Hauptenergiefluss, Hilfsenergiefluss und/oder Datenfluss derart miteinander verschaltet, dass sie in Reihe, das bedeutet seriell miteinander verschaltet sind, sodass jeweils mindestens ein Hauptenergiefluss, ein Hilfsenergiefluss und/oder ein Datenfluss bereitgestellt wird, von dem bzw. mit dem die Kontaktierungsaufnahmeelemente verbunden sind und von dem die Kontaktierungsaufnahmeelemente gespeist werden. Die Kontaktierungsaufnahmeelemente sind dabei insbesondere derart verschaltet, dass sie den Hauptenergiefluss, den Hilfsenergiefluss und/oder den Datenfluss aufnehmen und weiterleiten können.

Vorteilhafterweise kann bei der Erfindung vorgesehen sein, dass die Automatisierungsplattform weiter ein Brückenelement umfasst, das mit einer der Verbindungsvorrichtungen verbunden ist und das ausgebildet ist, zumindest einen von dem Hauptenergiefluss, dem Hilfsenergiefluss und/oder dem Datenfluss zu empfangen und an ein eine weitere Verbindungsvorrichtung bereitzustellen. Ein solches Brückenelement, das auch als Leerelement oder als Blindelement bezeichnet werden kann, kann in einer oder mehreren Kontaktierungsaufnahmeelemente von einer oder mehreren Verbindungsvorrichtungen aufgenommen werden und eine Weiterleitungsfunktionalität bereitstellen, insbesondere dann, wenn kein Funktionsmodul in der jeweiligen Verbindungsvorrichtung aufgenommen ist. Insbesondere ist das Brückenelement ausgebildet, in einem von einer Verbindungsvorrichtung aufgenommenen Zustand einen oder mehrere von dem Hauptenergiefluss, dem Hilfsenergiefluss und/oder dem Datenfluss aufzunehmen und an eine weitere Verbindungsvorrichtung weiterzuleiten, insbesondere durchzuschleifen und/oder zu überbrücken, sodass einer oder mehrere von dem Hauptenergiefluss, dem Hilfsenergiefluss und/oder dem Datenfluss, insbesondere bei einer seriellen Verschaltung, nicht unterbrochen wird. Darüber hinaus kann das Brückenelement auch das erste und/oder zweite Kontaktierungsaufnahmeelement vor äußeren Einflüssen, wie Staub oder Dreck schützen.

Ebenfalls optional unter Schutz gestellt ist ein System mit mindestens zwei (oder mindestens vier oder mindestens sechs) Automatisierungsplattformen, die jeweils optional als die voranstehend beschriebene erfindungsgemäße Automatisierungsplattform ausgebildet sein können. Dabei können die Automatisierungsplattformen jeweils als eine dezentrale Automatisierungsplattform ausgebildet sein und entsprechend dazu ausgebildet sein, jeweils Teilautomatisierungsfunktionen und insbesondere jeweils einen Teil einer Gesamtsteuerung für eine Automatisierung einer industriellen Anlage bereitzustellen. Dabei können die Automatisierungsplattformen dezentral im Feld der Anlage angeordnet sein, insbesondere, um gemeinsam eine Funktion eines zentralen Schaltschranks zu ersetzen. Weiter können die Automatisierungsplattformen über ein industrielles Kommunikationssystem und/oder einen Feldbus miteinander und/oder mit einer zentralen Steuerung verbunden sind.

Ebenfalls Gegenstand der Erfindung ist eine Anlage, vorzugsweise industrielle Anlage, mit mindestens zwei (oder mindestens vier oder mindestens sechs) Automatisierungsplattformen, die jeweils optional als die erfindungsgemäße Automatisierungsplattform ausgebildet sein können. Dabei können die Automatisierungsplattformen jeweils als eine dezentrale Automatisierungsplattform ausgebildet sein und entsprechend dazu ausgebildet sein, jeweils Teilautomatisierungsfunktionen und insbesondere jeweils einen Teil einer Gesamtsteuerung für die Automatisierung der industriellen Anlage bereitzustellen. Dabei können die Automatisierungsplattformen dezentral im Feld der Anlage angeordnet sein, insbesondere, um gemeinsam eine Funktion eines zentralen Schaltschranks zu ersetzen. Weiter können die Automatisierungsplattformen über ein industrielles Kommunikationssystem und/oder über einen Feldbus miteinander und/oder mit einer zentralen Steuerung verbunden sind. Die Automatisierungsplattformen können damit im Feld der Anlage verteilt und zusammen eingesetzt werden, um die Funktion des üblicherweise vorgesehenen zentralen Schaltschranks zu übernehmen. Dies kann den Vorteil haben, dass die Anlage flexibler gestaltet werden kann und insbesondere bei Erweiterungen oder Umbauten der Anlage eine einfache Anpassung der Automatisierungsfunktionen ermöglicht wird. Durch die dezentrale Anordnung der Automatisierungsplattformen kann zudem eine höhere Ausfallsicherheit erreicht werden, da bei einem Ausfall einer Plattform nicht die gesamte Automatisierung der Anlage betroffen ist. Es ist außerdem möglich, dass die Anlage durch die Verwendung der erfindungsgemäßen Automatisierungsplattformen kosteneffizienter gestaltet werden kann, da die Anschaffungskosten für einen zentralen Schaltschrank entfallen und die dezentrale Anordnung der Plattformen eine Reduktion der Verkabelungskosten ermöglicht.

Die jeweilige Automatisierungsplattform gemäß dem erfindungsgemäßen System und/oder der erfindungsgemäßen Anlage können optional umfassen: eine Verbindungsvorrichtung und/oder zumindest ein Funktionsmodul, wobei die (jeweilige) Verbindungsvorrichtung umfasst:
- ein Kontaktierungsaufnahmeelement, das ausgebildet ist, eine Kontaktierung mit einem zu dem Kontaktierungsaufnahmeelement korrespondierenden Kontaktierungselement eines/des Funktionsmoduls bereitzustellen und darüber zumindest einen von einem Hauptenergiefluss, einem Hilfsenergiefluss und einem Datenfluss an das Funktionsmodul bereitzustellen, und/oder
- ein Erdungsaufnahmeelement, das ausgebildet ist, eine Erdung für das Funktionsmodul bereitzustellen.

Die Automatisierungsplattformen können jeweils mit einer eigenen Stromversorgung und/oder einer Cloud-basierten Plattform zur Fernüberwachung und -steuerung und/oder einer integrierten Diagnosefunktion ausgestattet sein, um eine höhere Verfügbarkeit und Ausfallsicherheit, eine einfache Fehlerbehebung und eine automatische Fehlererkennung und -behebung zu gewährleisten. Dies kann den Vorteil haben, dass die Automatisierungsplattformen unabhängig von der Stromversorgung des Standorts betrieben werden können und somit für den Einsatz in verschiedenen Umgebungen geeignet sind. Es ist außerdem möglich, dass die Cloud-basierte Plattform zur Fernüberwachung und - steuerung es ermöglicht, dass die Automatisierungsplattformen von einem entfernten Standort aus überwacht und gesteuert werden können, was den Bedienkomfort erhöht. Die integrierte Diagnosefunktion kann dazu beitragen, dass mögliche Fehler schnell und einfach erkannt und behoben werden können, was die Wartung und Instandhaltung der Automatisierungsplattformen erleichtert und die Betriebskosten senkt.

Ein weiterer Vorteil der erfindungsgemäßen Automatisierungsplattform ist die Möglichkeit, einen digitalen Zwilling der industriellen Anlage zu erstellen und zu nutzen. Dabei handelt es sich insbesondere um eine virtuelle Darstellung der Anlage, die auf der Grundlage von Echtzeitdaten und Simulationen erstellt wird. Der digitale Zwilling kann dazu genutzt werden, um die Anlage zu optimieren, indem verschiedene Szenarien und Änderungen simuliert werden, bevor sie in der realen Anlage umgesetzt werden. Dies kann dazu beitragen, die Effizienz und Produktivität der Anlage zu steigern und gleichzeitig das Risiko von Fehlern und Ausfällen zu minimieren. Der digitale Zwilling kann auch dazu genutzt werden, um die Wartung und Instandhaltung der Anlage zu optimieren, indem mögliche Probleme frühzeitig erkannt und behoben werden können, bevor sie zu Ausfällen führen.

Die erfindungsgemäße Automatisierungsplattform bzw. die jeweilige Automatisierungsplattform einer erfindungsgemäße Anlage kann dazu ausgeführt sein, mehrere Funktionsmodule aufzunehmen, um diese über den Haupt- und/oder Hilfsenergiefluss mit Energie zu versorgen und/oder über den Datenfluss anzusteuern und/oder über den Datenfluss einen Datenaustausch für diese zu ermöglichen.

Die Funktionsmodule können unterschiedliche der Automatisierungsfunktionen, insbesondere in der Form von Teilautomatisierungsfunktionen, für die Automatisierung der industriellen Anlage bereitzustellen. Die Automatisierungsfunktionen können dabei wenigstens zwei der folgenden umfassen:
- Einen Motoransteuerung;
- Eine Ansteuerung und/oder Energieversorgung einer Motorsteuerung, welche vorzugsweise außerhalb der Automatisierungsplattform in Motornähe vorgesehen ist;
- Eine Ansteuerung und/oder Energieversorgung eines Aktuators, wie bspw. eines Motors, eines Ventils, eines Schrittmotors, eines Linearantriebs, eines Piezoaktors, eines Magnetaktors, eines Hydraulikzylinders, eines Pneumatikzylinders, eines Klappenantriebs, eines Greifarms, eines Roboterarms, eines Drehtisches, eines Förderbands, eines Kranarms, eines Schwenkarms, eines Bohrers, eines Schneiders, eines Schweißgeräts, eines Schneid- oder Gravierlasers, eines Vibrationsmotors, eines Lautsprechers, eines Aktors in der Medizintechnik, eines Aktors in der Automobilindustrie, eines Aktors in der Luft- und Raumfahrtindustrie, eines Aktors in der Robotik, eines Aktors in der Elektronik- oder Halbleiterindustrie, eines Aktors in der Lebensmittel- oder Verpackungsindustrie und/oder eines Aktors in der Textil- oder Papierindustrie;
- Ein Auslesen und/oder Ansteuern und/oder eine Energieversorgung eines Sensors, vorzugsweise eines Näherungssensors und/oder einer Lichtschranke.

Des Weiteren können die Funktionsmodule auch ein Sicherheitsmodul zur Überwachung und Absicherung von Prozessen und/oder einen Industrie-PC und/oder ein Feldbusmodul umfassen.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine perspektivische Ansicht auf eine Verbindungsvorrichtung gemäß Ausführungsbeispielen der Erfindung.
- Fig. 2: eine perspektivische Ansicht auf eine Verbindungsvorrichtung gemäß weiteren Ausführungsbeispielen der Erfindung
- Fig. 3: eine schematische Darstellung einer industriellen Anlage.

In den nachfolgenden Figuren werden für die gleichen technischen Merkmale auch von unterschiedlichen Ausführungsbeispielen die identischen Bezugszeichen verwendet.

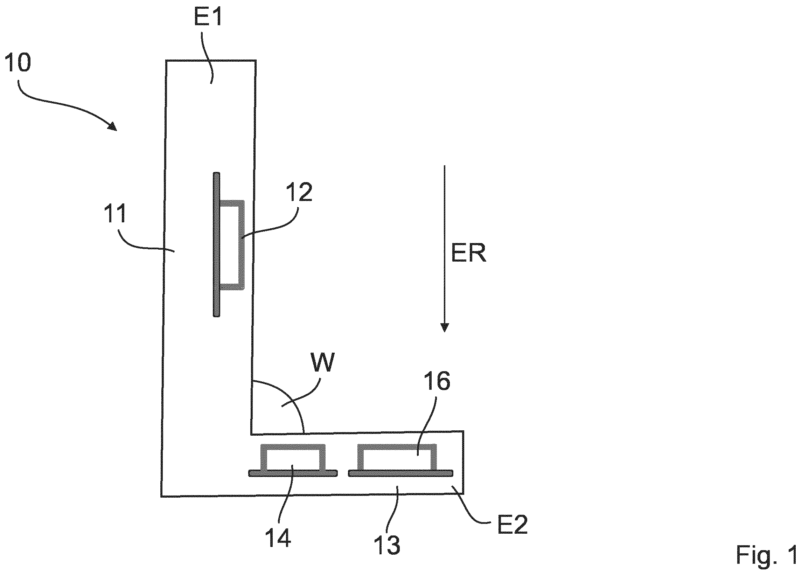

Fig. 1 veranschaulicht eine perspektivische Ansicht einer Verbindungsvorrichtung 10 gemäß Ausführungsbeispielen der Erfindung.

Die Verbindungsvorrichtung 10 dient zum Anschluss einer oder mehrerer Funktionsmodule an eine Automatisierungsplattform, welche hier nicht im Detail abgebildet ist. Insbesondere können mehrere solcher hier in dieser Fig. 1 gezeigten Verbindungsvorrichtungen vorgesehen sein, die insbesondere seriell miteinander verschaltet sind. Die Automatisierungsplattform kann beispielsweise mehrere Verbindungsvorrichtungen und optional ein oder mehrere Funktionsmodule umfassen.

Dazu umfasst die Verbindungsvorrichtung 10 zunächst ein erstes Kontaktierungsaufnahmeelement 12, das in einer ersten Ebene E1 angeordnet ist und das ausgebildet ist, eine erste Kontaktierung mit einem zu dem ersten Kontaktierungsaufnahmeelement 12 korrespondierenden ersten Kontaktierungselement eines Funktionsmoduls bereitzustellen. Die Verbindungsvorrichtung 10 kann auch ein zweites Kontaktierungsaufnahmeelement 14 umfassen, das in einer zweiten Ebene E2 angeordnet ist und das ausgebildet ist, eine zweite Kontaktierung mit einem zu dem zweiten Kontaktierungsaufnahmeelement 14 korrespondierenden zweiten Kontaktierungselement des Funktionsmoduls bereitzustellen. In dieser Fig. 1 ist zusätzlich noch ein weiteres optionales, drittes Kontaktierungsaufnahmeelement 16 gezeigt, das ebenfalls in der zweiten Ebene E2 angeordnet ist.

Die erste Ebene E1 ist dabei zu der zweiten Ebene E2 gewinkelt ausgebildet. Insbesondere spannen die erste Ebene E1 und die zweite Ebene E2 einen Winkel W zwischen sich auf, der im Wesentlichen bei 90° liegt. Wie in dieser Fig. 1 insbesondere zu sehen, ist liegt das erste Kontaktierungsaufnahmeelement 12 in einem ersten Schenkel 11 und das zweite Kontaktierungsaufnahmeelement 14 und das dritte Kontaktierungsaufnahmeelement 16 in einem zweiten Schenkel 13 der Verbindungsvorrichtung 10, wobei die beiden Schenkel im Wesentlichen ebenfalls senkrecht zueinander angeordnet sind bzw. sich ein rechter Winkel W zwischen den beiden Schenkeln aufspannt. Mit anderen Worten sind die beiden Schenkel 11 und 13 in einer L-Form zueinander angeordnet bzw. ist die Verbindungsvorrichtung 10 im Wesentlichen L-förmig ausgebildet.

Das erste Kontaktierungsaufnahmeelement 12 ist dabei ausgebildet, einen von einem Hauptenergiefluss, einem Hilfsenergiefluss und einem Datenfluss über das erste Kontaktierungselement an das Funktionsmodul bereitzustellen das zweite Kontaktierungsaufnahmeelement 14 ist ausgebildet, einen weiteren von einem Hauptenergiefluss, einem Hilfsenergiefluss und einem Datenfluss über das zweite Kontaktierungselement an das Funktionsmodul bereitzustellen. Insbesondere ist das dritte Kontaktierungsaufnahmeelement 16 ausgebildet, einen noch weiteren von einem Hauptenergiefluss, einem Hilfsenergiefluss und einem Datenfluss über das erste Kontaktierungselement an das Funktionsmodul bereitzustellen. Beispielsweise stellt das erste Kontaktierungsaufnahmeelement 12 einen Hauptenergiefluss, das zweite Kontaktierungsaufnahmeelement 14 einen Hilfsenergiefluss und das dritte Kontaktierungsaufnahmeelement 16 einen Datenfluss über entsprechende Kontaktierungen an das Funktionsmodul bereit.

Der Hauptenergiefluss kann dabei eine Wechselspannung von bis zu 1000 Volt und/oder eine Gleichspannung von bis zu 1500 Volt und/oder eine Wechselspannung im Bereich von 70 Volt bis 1000 Volt und/oder eine Gleichspannung im Bereich von 130 Volt bis 1500 Volt, und bevorzugt eine Wechselspannung von im Wesentlichen 400 Volt oder eine Gleichspannung im Bereich von 650 V bis 700 V, umfassen. Ebenso kann der Hilfsenergiefluss eine Wechselspannung von bis zu 50 Volt und/oder eine Gleichspannung bis zu 120 Volt und/oder eine Wechselspannung im Bereich von 0,01 Volt bis 50 Volt und/oder eine Gleichspannung im Bereich von 0,01 Volt bis 120 Volt, und bevorzugt eine Gleichspannung von im Wesentlichen 24 V oder 48 V umfassen.

Die Kontaktierung zwischen dem jeweiligen Kontaktierungsaufnahmeelement und dem dazu korrespondierenden Kontaktierungselement kann dabei beispielsweise als Stift-Buchsen-Kontaktierung als Federkontaktierung, insbesondere als Federklammer, und/oder als Flächenkontaktierung ausgebildet sein und insbesondere auch Kombinationen daraus umfassen. Insbesondere ist die Kontaktierung zwischen dem ersten Kontaktierungsaufnahmeelement 12 und dem dazu korrespondierenden Kontaktierungselement des Funktionsmoduls anders ausgebildet als die Kontaktierung zwischen dem zweiten Kontaktierungsaufnahmeelement 14 und dem dazu korrespondierenden Kontaktierungselement des Funktionsmoduls bzw. sind die beiden Kontaktierungsarten verschieden.

Das hier in dieser Fig. 1 nicht gezeigte Funktionsmodul kann dabei insbesondere in der durch den Pfeil angezeigten Einführrichtung ER eingeführt werden, die im Wesentlichen parallel zu der ersten Ebene E1 und im Wesentlichen senkrecht zu der zweiten Ebene E2 liegt, um so das erste Kontaktierungsaufnahmeelement 12, das zweite Kontaktierungsaufnahmeelement 14 und optional das dritte Kontaktierungsaufnahmeelement 16 zu kontaktieren, wie dies nun im Zusammenhang mit den weiteren Figuren beschrieben werden wird.

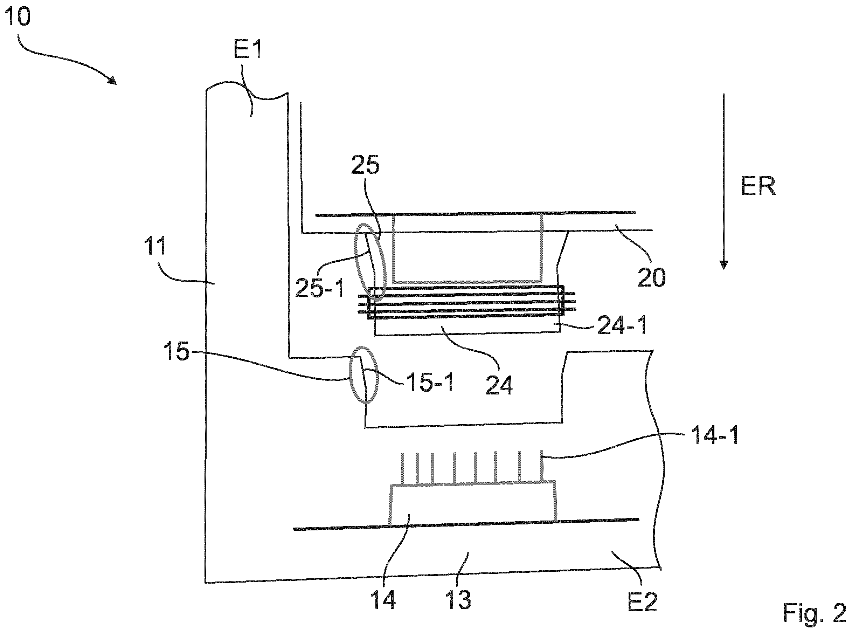

Die Verbindungsvorrichtung 10 umfasst auch ein in dieser Fig. nicht im Detail gezeigtes Erdungsaufnahmeelement 15, das ausgebildet ist, eine Erdung für das Funktionsmodul bereitzustellen, wie dies im Zusammenhang mit der folgenden Fig. 2 im Detail erläutert werden wird. Insbesondere kann das Erdungsaufnahmeelement als Formschlussaufnahmeelement, als Befestigungsaufnahmeelement, als Erdungsflächenaufnahmeelement, als Erdungsbandaufnahmeelement und/oder als Erdungskabelaufnahmeelement ausgebildet sein, das mit einem dazu korrespondierenden Element an dem Funktionsmodul eingreift und/oder interagiert, um dadurch eine Erdung von dem bzw. an das Funktionsmodul bereitzustellen.

Fig. 2 veranschaulicht eine perspektivische Ansicht einer Verbindungsvorrichtung 10 gemäß weiteren Ausführungsbeispielen der Erfindung.

Wie hier in dieser Fig. 2 im Detail gezeigt, weist die Verbindungsvorrichtung ein Erdungsaufnahmeelement 15 auf, welches eine Erdung von dem bzw. an das hier ebenfalls abgebildete Funktionsmodul 20 bereitstellt. Das Erdungsaufnahmeelement 15 ist hier beispielshaft dergestalt gezeigt, dass es ein Formschlussaufnahmeelement 15-1 aufweist auf bzw. als ein solches ausgebildet ist. Das Funktionsmodul 20 weist ein zu dem Erdungsaufnahmeelement 15 korrespondierendes Erdungselement 25 auf und ist hier beispielhaft als Formschlusselement 25-1 gezeigt, das formschlüssig mit dem Formschlussaufnahmeelement 15-1 ineinandergreift. Beispielhaft ist das Erdungselement 15 hier als an dem zweiten Kontaktierungsaufnahmeelement 14 angeordnet abgebildet. Es versteht sich jedoch, dass alternativ oder zusätzlich auch ein Erdungselement 15 an dem ersten Kontaktierungsaufnahmeelement und/oder an dem dritten Kontaktierungsaufnahmeelement, wie in Fig. 1 gezeigt, angeordnet sein kann.

Ebenfalls in dieser Fig. 2 gezeigt ist im Detail eine Art der Kontaktierung zwischen dem zweiten Kontaktierungsaufnahmeelement 14 und dem dazu korrespondierenden Kontaktierungselement 24 des Funktionsmoduls 20. Diese ist hier beispielhaft als Stift-Buchsen-Kontaktierung gezeigt, wobei das zweite Kontaktierungsaufnahmeelement 14 eine bzw. mehrere Stiftkontaktierungen 14-1 aufweist und das dazu korrespondierende Kontaktierungselement 24 eine bzw. mehrere Buchsenkontaktierungen 24-1, die ausgebildet sind, die Stiftkontaktierungen 14-1 aufzunehmen und somit eine Kontaktierung zwischen dem Funktionsmodul 20 und der Verbindungsvorrichtung 10 herzustellen.

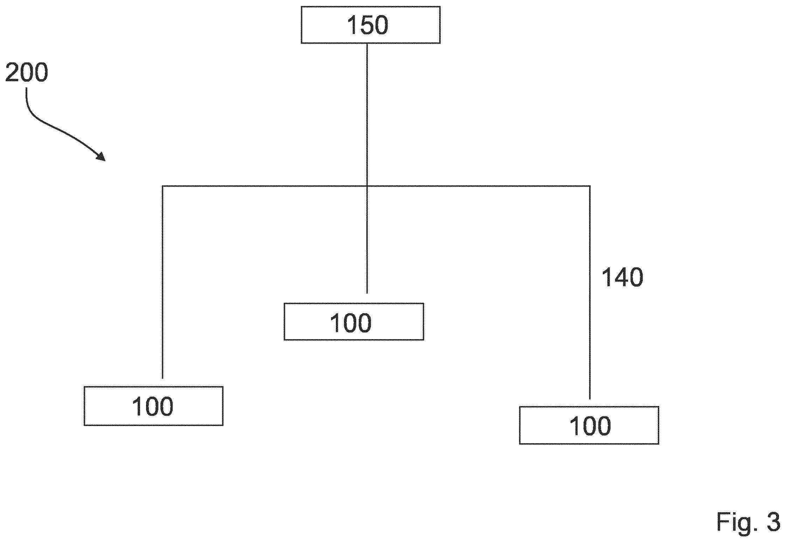

In Fig. 3 ist schematisch eine industrielle Anlage 200 mit mindestens zwei Automatisierungsplattformen 100 dargestellt. Dabei können die Automatisierungsplattformen 100 jeweils als eine dezentrale Automatisierungsplattform 100 ausgebildet sein, und entsprechend dazu ausgebildet sein, jeweils Teilautomatisierungsfunktionen und insbesondere jeweils einen Teil einer Gesamtsteuerung für die Automatisierung der industriellen Anlage 200 bereitzustellen. Hierzu können die Automatisierungsplattformen 100 dezentral im Feld der Anlage 200 angeordnet sein, insbesondere, um gemeinsam eine Funktion eines zentralen Schaltschranks zu ersetzen, wobei die Automatisierungsplattformen 100 über einen Feldbus 140 miteinander und/oder mit einer zentralen Steuerung 150 verbunden sind.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Verbindungsvorrichtung
- 11: erster Schenkel
- 12: erstes Kontaktierungsaufnahmeelement
- 13: zweiter Schenkel
- 14-1: Stiftkontaktierung
- 15: Erdungsaufnahmeelement
- 15-1: Formschlussaufnahmeelement
- 16: drittes Kontaktierungsaufnahmeelement
- 20: Funktionsmodul
- 22: erstes Kontaktierungselement
- 24-1: Buchsenkontaktierung
- 25: Erdungselement
- 25-1: Formschlusselement
- E1: erste Ebene
- E2: zweite Ebene
- ER: Einführrichtung
- W: Winkel

## Patentansprüche

1. Verbindungsvorrichtung (10) für eine Automatisierungsplattform, umfassend:
- ein Kontaktierungsaufnahmeelement (12), das ausgebildet ist, eine Kontaktierung mit einem zu dem Kontaktierungsaufnahmeelement (12) korrespondierenden Kontaktierungselement (22) eines Funktionsmoduls (20) bereitzustellen und darüber zumindest einen von einem Hauptenergiefluss, einem Hilfsenergiefluss und einem Datenfluss an das Funktionsmodul (20) bereitzustellen; und
- ein Erdungsaufnahmeelement (15), das ausgebildet ist, eine Erdung für das Funktionsmodul (20) bereitzustellen.

2. Verbindungsvorrichtung (10) nach Anspruch 1,
**dadurch gekennzeichnet,**
**dass** das Erdungsaufnahmeelement (15) ein Formschlussaufnahmeelement (15-1) aufweist, wobei das Formschlussaufnahmeelement (15-1) ausgebildet ist, formschlüssig mit einem dazu korrespondierenden Formschlusselement (25-1) des Funktionsmoduls (20) einzugreifen, um dadurch eine Erdung bereitzustellen.

3. Verbindungsvorrichtung (10) nach einem der vorhergehenden Ansprüche,
**dadurch gekennzeichnet,**
**dass** das Erdungsaufnahmeelement (15) ein Befestigungsaufnahmeelement aufweist, wobei das Befestigungsaufnahmeelement ausgebildet ist, an einem dazu korrespondierenden Befestigungselement des Funktionsmoduls (20) befestigt zu werden, um dadurch eine Erdung bereitzustellen.

4. Verbindungsvorrichtung (10) nach einem der vorhergehenden Ansprüche,
**dadurch gekennzeichnet,**
**dass** das Erdungsaufnahmeelement (15) ein Erdungsflächenaufnahmeelement aufweist, wobei das Erdungsflächenaufnahmeelement ausgebildet ist, flächig mit einem dazu korrespondierenden Erdungsflächenelement des Funktionsmoduls (20) einzugreifen, um dadurch eine Erdung bereitzustellen.

5. Verbindungsvorrichtung (10) nach einem der vorhergehenden Ansprüche,
**dadurch gekennzeichnet,**
**dass** das Erdungsaufnahmeelement (15) ein Erdungsbandaufnahmeelement aufweist, wobei das Erdungsbandaufnahmeelement ausgebildet ist, mit einem dazu korrespondierenden Erdungsbandelement des Funktionsmoduls (20) einzugreifen, um dadurch eine Erdung bereitzustellen.

6. Verbindungsvorrichtung (10) nach einem der vorhergehenden Ansprüche,
**dadurch gekennzeichnet,**
**dass** das Erdungsaufnahmeelement (15) ein Erdungskabelaufnahmeelement aufweist, wobei das Erdungskabelaufnahmeelement ausgebildet ist, mit einem dazu korrespondierenden Erdungskabelelement des Funktionsmoduls (20) einzugreifen, um dadurch eine Erdung bereitzustellen.

7. Verbindungsvorrichtung (10) nach einem der vorhergehenden Ansprüche,
**dadurch gekennzeichnet,**
**dass** der Hauptenergiefluss eine Wechselspannung von bis zu 1000 Volt und/oder eine Gleichspannung von bis zu 1500 Volt und/oder eine Wechselspannung im Bereich von 70 Volt bis 1000 Volt und/oder eine Gleichspannung im Bereich von 130 Volt bis 1500 Volt, und bevorzugt eine Wechselspannung von im Wesentlichen 400 Volt oder eine Gleichspannung im Bereich von 650 V bis 700 V, umfasst.
und/oder
**dass** der Hilfsenergiefluss eine Wechselspannung von bis zu 50 Volt und/oder eine Gleichspannung bis zu 120 Volt und/oder eine Wechselspannung im Bereich von 0,01 Volt bis 50 Volt und/oder eine Gleichspannung im Bereich von 0,01 Volt bis 120 Volt, und bevorzugt eine Gleichspannung von im Wesentlichen 24 V oder 48 V umfasst.

8. Verbindungsvorrichtung (10) nach einem der vorhergehenden Ansprüche,
**dadurch gekennzeichnet,**
**dass** die Verbindungsvorrichtung (10) ein weiteres Kontaktierungsaufnahmeelement (14) umfasst, das ausgebildet ist, eine Kontaktierung mit einem zu dem weiteren Kontaktierungsaufnahmeelement (14) korrespondierenden weiteren Kontaktierungselement (24) des Funktionsmoduls (20) bereitzustellen und darüber zumindest einen weiteren von einem Hauptenergiefluss, einem Hilfsenergiefluss und einem Datenfluss an das Funktionsmodul (20) bereitzustellen.

9. Verbindungsvorrichtung (10) nach Anspruch 8,
**dadurch gekennzeichnet,**
**dass** das Kontaktierungsaufnahmeelement (12) in einer ersten Ebene (E1) angeordnet ist und das weitere Kontaktierungsaufnahmeelement (14) in einer zweiten Ebene (E2), die zu der ersten Ebene (E1) gewinkelt ist, angeordnet ist.

10. Verbindungsvorrichtung (10) nach Anspruch 8 oder 9,
**dadurch gekennzeichnet,**
**dass** das Erdungsaufnahmeelement (15) an dem Kontaktierungsaufnahmeelement (12) angeordnet ist und die Verbindungsvorrichtung (10) ein weiteres Erdungsaufnahmeelement umfasst, das an dem weiteren Kontaktierungsaufnahmeelement (14) angeordnet ist.

11. Automatisierungsplattform, umfassend eine Verbindungsvorrichtung (10) nach einem der vorhergehenden Ansprüche sowie zumindest ein Funktionsmodul (20).

12. Automatisierungsplattform nach Anspruch 11, umfassend eine weitere Verbindungsvorrichtung nach einem der Ansprüche 1 bis 10, wobei jede der Verbindungsvorrichtungen mit zumindest je einem Funktionsmodul verbindbar ist, wobei die Verbindungsvorrichtungen ausgebildet sind, um zumindest einen von dem Hauptenergiefluss, dem Hilfsenergiefluss und dem Datenfluss an die Funktionsmodule bereitzustellen, wobei insbesondere jedes der Funktionsmodule eine unterschiedliche Funktion für die Automatisierungsplattform bereitstellt.

13. Automatisierungsplattform nach Anspruch 12,
**dadurch gekennzeichnet,**
**dass** die Verbindungsvorrichtungen derart zueinander angeordnet und ausgebildet sind, dass sie zumindest einen von dem Hauptenergiefluss, dem Hilfsenergiefluss und/oder dem Datenfluss seriell an die Funktionsmodule bereitzustellen.

14. Automatisierungsplattform nach einem der Ansprüche 10 bis 13,
weiter umfassend ein Brückenelement, das mit einer der Verbindungsvorrichtungen verbunden ist und das ausgebildet ist, zumindest einen von dem Hauptenergiefluss, dem Hilfsenergiefluss und dem Datenfluss zu empfangen und an ein eine weitere Verbindungsvorrichtung bereitzustellen.

15. Industrielle Anlage (200) mit mindestens zwei Automatisierungsplattformen (100), insbesondere jeweils nach einem der Ansprüche 11 bis 14,
jeweils umfassend eine Verbindungsvorrichtung (10) sowie zumindest ein Funktionsmodul (20), wobei die Verbindungsvorrichtung (10) umfasst:
- ein Kontaktierungsaufnahmeelement (12), das ausgebildet ist, eine Kontaktierung mit einem zu dem Kontaktierungsaufnahmeelement (12) korrespondierenden Kontaktierungselement (22) des Funktionsmoduls (20) bereitzustellen und darüber zumindest einen von einem Hauptenergiefluss, einem Hilfsenergiefluss und einem Datenfluss an das Funktionsmodul (20) bereitzustellen, und
- ein Erdungsaufnahmeelement (15), das ausgebildet ist, eine Erdung für das Funktionsmodul (20) bereitzustellen
**dadurch gekennzeichnet,**
**dass** die Automatisierungsplattformen (100) jeweils als eine dezentrale Automatisierungsplattform (100) ausgebildet sind, und entsprechend dazu ausgebildet sind, jeweils Teilautomatisierungsfunktionen und insbesondere jeweils einen Teil einer Gesamtsteuerung für die Automatisierung der industriellen Anlage (200) bereitzustellen, wobei die Automatisierungsplattformen (100) dezentral im Feld der Anlage (200) angeordnet sind, insbesondere, um gemeinsam eine Funktion eines zentralen Schaltschranks zu ersetzen, wobei die Automatisierungsplattformen (100) über einen Feldbus (140) miteinander und/oder mit einer zentralen Steuerung (150) verbunden sind.
